# EUROPEAN PATENT APPLICATION

(11) **EP 4 783 818 A2**
(43) Date of publication of application: **29.07.2026**
(21) Application number: 26184480.7
(22) Date of filing: 01.02.2024
(51) Int. Cl.: H10W 46/00

(54) **SOLAR CELL AND PHOTOVOLTAIC MODULE**

(30) Priority: 19.09.2023 CN 202311209245
(62) Divisional of application: 24155306.4
(71) Applicant: Jinko Solar (Haining) Co., Ltd., Haining City, Zhejiang (CN); Zhejiang Jinko Solar Co., Ltd., Haining, Zhejiang 314416 (CN)
(72) Inventor: TAO, Wusong, Zhejiang (CN); WANG, Luchuang, Zhejiang (CN); QIN, Niannian, Zhejiang (CN)
(74) Representative: Rösler Rasch van der Heide & Partner

(57) **Abstract**

A solar cell and a photovoltaic module; and the photovoltaic module includes a substrate, busbars, and at least one marker. The busbars are arranged on a same side of the substrate, and include at least a first busbar and a second busbar, the first busbar and the second busbar have opposite polarities, the first busbar has a first pad, the second busbar has a second pad, the first pad and the second pad are arranged sequentially along a straight line parallel to an arrangement direction of the busbars, and a distance from a marker to the first pad is different from a distance from a same marker to the second pad.

## Description

### TECHNICAL FIELD

The present application relates to the technical field of solar devices, and in particular, to a solar cell and a photovoltaic module.

### BACKGROUND

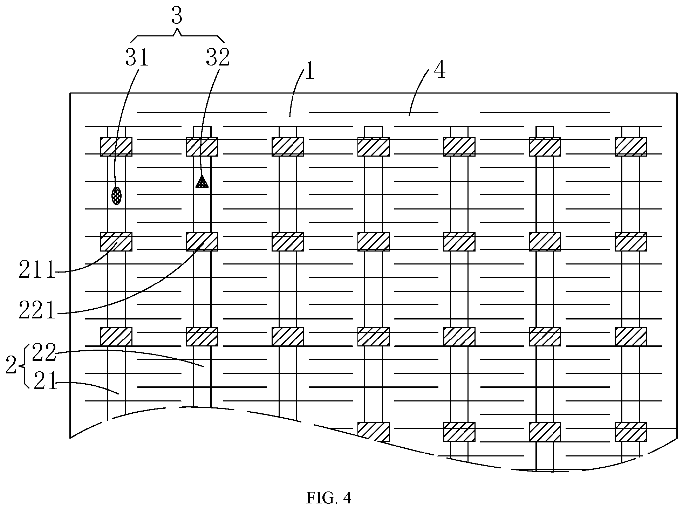

A back contact solar cell (IBC) means that there is no electrode on a front surface of the solar cell, and metal gate lines of positive and negative electrodes are arranged on a back surface of the solar cell in an interdigitated manner. Since the gate lines of the positive and negative electrodes are on a same side of the solar cell and are arranged crosswise, it is impossible to distinguish a positive busbar from a negative busbar in use, which makes electrical connection of solar cells more difficult. Prior art document includes CN104362190, and this prior art document discloses an interdigital electrode for a solar battery. The interdigital electrode is disposed on the shady face of a solar cell and composed of a positive pole and a negative pole; each of the positive pole and the negative pole is composed of main grid lines and auxiliary grid lines; the main grid lines are perpendicular to and connected with the auxiliary grid lines; each main grid line is made by connecting more than two thick grid segments though thin grid lines; the auxiliary grid lines of the positive pole and those of the negative pole are mutually parallel and are mutually spaced. The interdigital electrode with the structure has the advantages that current of the solar battery can be guided out in a balanced way, series and parallel connection of the solar batteries is favored, and welding tension of the interdigital electrode on back-contact solar batteries is higher. Specifically, Fig. 4 relates to an IBC cell having a mark 4 for distinguishing the polarity of the grid lines.

### SUMMARY

An objective of the present application is to provide a solar cell and a photovoltaic module, so as to solve the problem of distinction between positive and negative electrodes of the busbar. The invention is set forth as claimed in the attached set of claims.

The present application provides a solar cell, wherein the solar cell includes:
a substrate;
busbars, arranged on a same side of the substrate; and
at least one marker, arranged on the substrate;
wherein the busbars include at least a first busbar and a second busbar, the first busbar and the second busbar have opposite polarities, the first busbar has at least one first pad, the second busbar has at least one second pad, the first pad and the second pad are arranged sequentially along a straight line parallel to an arrangement direction of the busbars, and a distance from a same marker to the first pad is different from a distance to the second pad.

In accordance with the invention, an odd number of busbars are provided, and along the arrangement direction of the busbars, adjacent busbars have opposite polarities.

In some embodiments, the solar cell includes at least two markers.

In some embodiments, the markers are arranged on the busbars.

In some embodiments, along the arrangement direction of the busbars, two outermost busbars are the first busbars, the busbar adjacent to the first busbars is the second busbar, and the markers include a first marker and a second marker;
wherein the first marker is arranged on one of the first busbars, the second marker is arranged on the second busbar not adjacent to the first busbar, and a distance from the first marker to the corresponding first pad is different from a distance from the second marker to the corresponding second pad.

In some embodiments, the markers include a first marker and a second marker, wherein the first marker is arranged on the first busbar, and the second marker is arranged on the second busbar; and
the first marker and the second marker have different shapes.

In accordance with the invention, the first busbar is adjacent to the second busbar, and along the arrangement direction of the busbars, the marker is located between the first busbar and the second busbar.

In accordance with the invention, a distance from the marker to the first busbar is represented as a, a distance from the marker to the second busbar is represented as b, and a≠b.

In some embodiments, the distance a from the marker to the first busbar satisifies 9 mm≤a≤18 mm, and the distance b from the marker to the second busbar is 9 mm≤b≤18 mm, and/or a distance difference |a-b| between the distance a from the marker to the first busbar and the distance b from the marker to the second busbar satisfies 1 mm≤|a-b|≤9 mm.

In some embodiments, the at least one markers include a first marker and a second marker, wherein the first marker is located on a side of the second marker close to the first busbar, and the second marker is located on a side of the first marker close to the second busbar; and
the first marker and the second marker have different shapes.

In some embodiments, a distance m from the marker to the first pad satisifies 9 mm≤m≤18 mm, a distance from the marker to the second pad is n, 9 mm≤n≤18 mm, and/or
the distance from the marker to the first pad is m, the distance from the marker to the second pad is n, and 1 mm≤|m-n|≤9 mm.

In some embodiments, an area of a single marker is 0.3 mm² to 4 mm².

In some embodiments, the marker is in a shape of at least one of a circle, a rectangle, and a triangle.

In some embodiments, the marker is made of silver paste.

The present application further provides a photovoltaic module, wherein the photovoltaic module includes a solar cell, wherein the solar cell includes a substrate, busbars, and at least one marker, the busbars are arranged on a same side of the substrate, and the marker is arranged on the substrate and/or the busbars;
wherein the busbars include at least a first busbar and a second busbar, the first busbar and the second busbar have opposite polarities, the first busbar has a first pad, the second busbar has a second pad, the first pad and the second pad are arranged sequentially along a straight line parallel to an arrangement direction of the busbars, and a distance from a same marker to the first pad is different from a distance to the second pad.

The present application discloses a solar cell and a photovoltaic module. The photovoltaic module includes a substrate, busbars, and at least one marker. The busbars are arranged on a same side of the substrate, and include at least a first busbar and a second busbar, the first busbar and the second busbar have opposite polarities, the first busbar has a first pad, the second busbar has a second pad, the first pad and the second pad are arranged sequentially along a straight line parallel to an arrangement direction of the busbars, and a distance from a same marker to the first pad is different from a distance to the second pad. Through such a design, the polarity of the corresponding busbar can be judged as positive or negative according to distances from the marker to different pads, which is conducive to identifying the polarity of the busbar and facilitating electrical connection of solar cells.

### BRIEF DESCRIPTION OF DRAWINGS

FIG. 1 is a schematic diagram of some embodiments of a solar cell according to the present application;
FIG. 2 is a schematic diagram of some embodiments of the solar cell according to the present application;
FIG. 3 is a schematic diagram of some embodiments of the solar cell according to the present application; and
FIG. 4 is a schematic diagram of some embodiments of the solar cell according to the present application.

### Reference signs:

1: substrate;
2: busbar;
   21: first busbar;
      211: first pad;
   22: second busbar;
      221: second pad;
3: marker;
   31: first marker;
   32: second marker;
4: finger.

### DESCRIPTION OF EMBODIMENTS

Some embodiments described below with reference to the drawings are exemplary and are only used to explain the present disclose and cannot be construed as limiting the present application.

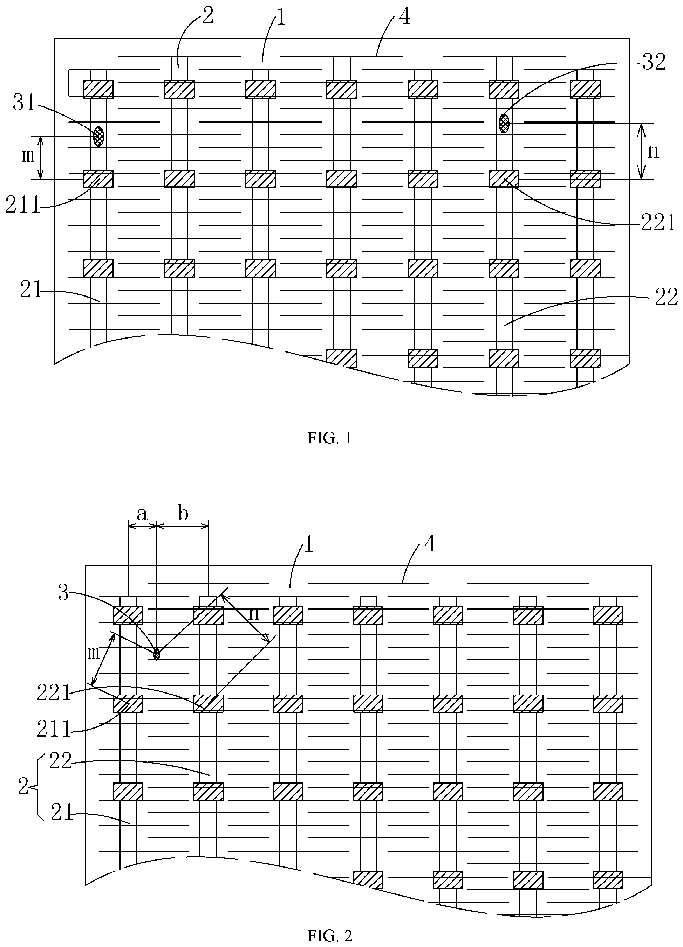

As shown in FIG. 1, some embodiments of the present application provide a solar cell. The solar cell includes a substrate 1, busbars 2, and at least one marker 3. The busbars 2 are arranged on a same side of the substrate 1. The marker 3 may be arranged on the substrate 1 and/or the busbars 2. The busbars 2 include at least a first busbar 21 and a second busbar 22, and the first busbar 21 and the second busbar 22 have opposite polarities. That is, the first busbar 21 is positive, and the second busbar 22 is negative, or the first busbar 21 is negative, and the second busbar 22 is positive. The first busbar 21 has a first pad 211, the second busbar 22 has a second pad 221, and the first pad 211 and the second pad 221 are arranged sequentially along a straight line parallel to an arrangement direction of the busbars 2. Furthermore, the first pad 211 and the second pad 221 are two adjacent pads, which are arranged in two busbars 2 having opposite polarities, and are arranged in a direction that intersects with arrangement direction of the busbars 2 A distance from a same marker 3 to the first pad 211 is different from a distance from the marker 3 to the second pad 221.

The busbars 2 are arranged on a same side of the substrate 1, so that the solar cell is formed as an IBC. A side with the busbars 2 is a back surface, and a side without the busbars 2 is a front surface. The most prominent feature of the IBC is that PN junctions and metal contact are on the back surface of the solar cell and the front surface is not shielded by the metal electrodes, so there is a higher short-circuit current, and at the same time, the back surface may be provided with wider metal electrodes to reduce series resistance so as to improve a fill factor. In conjunction with open-circuit voltage gain brought by a front surface field (FSF) and a good passivation effect of the solar cell, the solar cell with the unshielded front surface has high conversion efficiency and looks more beautiful. At the same time, it is easier to assemble a full back electrode module. In use, identification may be performed through the marker 3, according to the different distances from different busbars 2 to the marker 3, whether the corresponding busbar 2 is positive or negative can be distinguished, which is convenient for use, reduces the possibility of unclear distinction between the positive and negative electrodes, and is conducive to improving product quality and machining accuracy.

It is to be noted herein that "parallel" herein does not mean parallel in an absolute sense, but an approximately parallel state. During actual machining, affected by factors such as machining accuracy and pad shapes, a line connecting the first pad 211 and the second pad 221 may not be completely parallel to the arrangement direction of the busbars 2. Generally, the first pad 211 and the second pad 221 are in a same row.

In some embodiments, a same busbar 2 may be provided with 3 to 8 pads. For example, a quantity of the pads of the same busbar 2 may be 3, 4, 5, 6, 7, or 8. Any pad arranged on the first busbar 21 may be selected as the first pad 211. Among the pads located on the second busbar 22, a pad in a same row as the first pad 211 may be used as the second pad 221.

In some embodiments, an odd number of busbars 2 are provided, and along the arrangement direction of the busbars 2, adjacent busbars 2 have opposite polarities.

The quantity of the busbars 2 may be an odd number such as 3, 5, 7, 9, 11, or 13. The adjacent busbars 2 have opposite polarities, and the busbars 2 with the positive polarity and the busbars 2 with the negative polarity are arranged in a staggered manner. Along the arrangement direction of the busbars 2, electrodes of the first busbar 2 and the last busbar 2 are the same. In use, whether the corresponding busbars 2 are positive or negative can be judged through the marker 3, which is convenient for use.

When the quantity of the busbars 2 of the solar cell is an even number, since the positive busbars 2 and the negative busbars 2 are arranged in a staggered manner, the first bus 2 and the last busbar 2 have opposite polarities. When solar cells are electrically connected, the positive and negative electrodes can be distinguished by chamfering. When busbars 2 of adjacent solar cells have different polarities, one of the solar cells is rotated by 180°. In the solar cell provided with an odd number of busbars 2, the first bus 2 and the last busbar 2 have the same polarity. Even if the solar cell is rotated by 180°, the polarity of the busbar 2 at the corresponding position may not change. Therefore, there is a need to judge whether the busbar 2 is positive or negative. In the solution provided in some embodiments of the present application, the marker 3 may be arranged on the solar cell to distinguish whether the corresponding polarity of the busbar 2 is positive or negative, so that electrical connection can be made according to the polarity of the corresponding busbar 2 to improve accuracy of the electrical connection and improve product quality, which is more in line with an actual usage requirement.

As shown in FIG. 1, in some embodiments, the solar cell includes at least two markers 3.

A quantity of the marker 3 may be two, three, four, five, six, seven, or more. The arrangement of a plurality of markers 3 can make it easier to distinguish the polarity of the busbar 2. Moreover, when a single marker 3 is damaged and cannot be used for identification, other markers 3 can be used for identification, which is helpful to reduce a possibility of impossible identification of the polarity of the busbar 2 of the solar cell due to damages to the markers 3, thereby helping to improve machining efficiency and machining quality of the solar cell.

As shown in FIG. 1, in some embodiments, the marker 3 is arranged on the busbar 2. When the solar cell is provided with a plurality of markers 3, the markers 3 may be arranged on the first busbar 21 and the second busbar 22 respectively.

Through the arrangement of the marker 3 on the busbar 2, a possibility of simultaneous contact of the marker 3 with a plurality of busbars 2 and/or fingers 4 can be reduced. When the marker 3 is in contact with the plurality of busbars 2 and/or fingers 4 at the same time, it is easy to cause a short circuit in the solar cell, thereby affecting normal use of the solar cell and posing safety risks.

Each marker 3 may be used to mark the positive or negative electrode respectively. According to the polarities of the busbars 2, distances from the marker 3 to the pads corresponding to the busbars 2 are different. For example, a distance from the marker 3 arranged on the positive busbar 2 to the pad of the corresponding busbar 2 is L1, a distance from the marker 3 arranged on the negative positive busbar 2 to the pad of the corresponding busbar 2 is L2, and L1 is not equal to L2. In use, the distances from the marker 3 to the pads of the corresponding busbars 2 may be measured respectively. Since the distances from the marker 3 to the pads of the corresponding busbars 2 are different, the marker 3 can be used to identify the busbars 2, and then the polarities of the busbars 2 can be known, so as to facilitate the electrical connection of the solar cells, which is more in line with an actual usage requirement.

In some embodiments, the marker 3 may include a first marker 31 and a second marker 32. The first marker 31 is arranged on the first busbar 21, and the second marker 32 is arranged on the second busbar 22. A positive busbar is selected as the first busbar 21, and a negative busbar is selected as the second busbar 22. A distance from the marker 3 located on the positive busbar to the pad of the corresponding busbar 2 may be preset to be greater than a distance from the marker 3 located on the negative busbar to the pad of the corresponding busbar 2. In use, the distances from the marker 3 to the pads of the corresponding busbars 2 may be measured and compared, the longer distance corresponds to the positive busbar, and the shorter distance corresponds to the negative busbar, so as to know the polarities of the corresponding busbars 2 and understand polarity information of the busbars 2 of the solar cell, which facilitates use.

As shown in FIG. 1, in some embodiments, along the arrangement direction of the busbars 2, two outermost busbars 2 are the first busbars 21, the busbar 2 adjacent to the first busbars 21 is the second busbar 22, and the marker 3 includes a first marker 31 and a second marker 32. The first marker 31 is arranged on one of the first busbars 21, and the second marker 32 is arranged on the second busbar 22 not adjacent to the first busbar 21. A distance from the first marker 31 to the first pad 211 of the corresponding first busbar 21 is m, a distance from the second marker 32 to the second pad 221 of the corresponding second busbar 22 is n, and m is not equal to n.

During the identification, the corresponding busbars 2 can be identified as the first busbar 21 and the second busbar 22 through the distances from the first marker 31 and the second marker 32 to the corresponding pads, thereby knowing the polarities of the busbars 2. Since the busbars 2 with the positive polarity and the busbars 2 with the negative polarity of the solar cell are arranged in a staggered manner, a polarity arrangement rule of the busbars 2 of the solar cell can be acquired, thereby knowing whether the corresponding busbar 2 is positive or negative. The first busbar 21 and the second busbar 22 are respectively provided with the first marker 31 and the second marker 32 and have different polarities. Therefore, whether the corresponding busbar 2 is positive or negative can be distinguished according to the first marker 31 and the second marker 32, thereby facilitating use.

Through such a design, the first marker 31 and the second marker 32 are respectively arranged on two opposite ends of the solar cell, which can reduce a possibility of simultaneous damages to the first marker 31 and the second marker 32 and can also identify the polarity of the busbar 2 from the two ends, which is conducive to increasing accuracy of the identification.

As shown in FIG. 1, in some embodiments, an odd number of busbars 2 are provided, and along the arrangement direction of the busbars 2, the first busbar 2 is the first busbar 21, the penultimate busbar 2 is the second busbar 22, the first marker 31 is arranged on the first busbar 21, and the second marker 32 is arranged on the second busbar 22.

Through such a design, polarities of the first busbar 21 and the second busbar 22 can be judged respectively. Since the busbars 2 of the solar cell are arranged in a staggered manner according to the positive and negative electrodes, along the arrangement direction of the busbars 2, the polarity of the first busbar 2 is the same as the polarity of the last busbar 2. When the first busbar 2 is positive, the last busbar 2 is also positive, and the second busbar 2 and the penultimate busbar 2 are negative. When the first busbar 2 is negative, the last busbar 2 is also negative, and the second busbar 2 and the penultimate busbar 2 are positive. Therefore, the markers 3 are arranged on the first busbar 2 and the penultimate busbar 2 respectively, and the busbars 2 with different polarities can be marked. During the identification, the busbars 2 with different polarities can be identified respectively through the markers 3, and information of positive busbars and negative busbars can be acquired simultaneously, thereby being conducive to distinguishing whether the corresponding busbar 2 is positive or negative and improving accuracy of the identification, which is more in line with an actual usage requirement.

As shown in FIG. 2, in some embodiments, the first busbar 21 is adjacent to the second busbar 22, and along the arrangement direction of the busbars 2, the solar cell includes a marker 3, and the marker 3 is located between the first busbar 21 and the second busbar 22. A distance from the marker 3 to the first pad 211 of the first busbar 21 is m, a distance from the marker 3 to the second pad 221 of the second busbar 22 is n, and m is not equal to n.

Through such a design, polarities of adjacent busbars 2 can be distinguished by a marker 3. Since the solar cell is provided with an odd number of busbars 2 and positive busbars 2 and negative busbars 2 are arranged in a staggered manner, after polarities of two adjacent busbars 2 are confirmed, polarities of the remaining busbars 2 can also be confirmed according to the arrangement rule, so as to determine whether the polarity of each busbar 2 is positive or negative. Such a design can reduce the quantity of the marker 3, thereby reducing costs and improving manufacturing efficiency, which is more in line with an actual usage requirement.

As shown in FIG. 2, in some embodiments, a distance from the marker 3 to the first busbar 21 is a, a distance from the marker 3 to the second busbar 22 is b, and a is not equal to b.

Through such a design, in use, the polarity of the corresponding busbar 2 can be identified by identifying the distances from the marker 3 to different busbars 2.

The marker 3 is arranged between adjacent busbars 2, which can reduce the quantity of the marker 3. Two adjacent busbars 2 can be identified through a single marker 3, so as to know corresponding polarities of the two adjacent busbars 2, and then polarities of the remaining busbars 2 are acquired according to an arrangement rule of the busbars 2, so as to know arrangement information of the busbars 2 of the solar cell. During the identification, comprehensive judgment can be made by combining the distances from the marker 3 to the busbar 2 and the distance from the marker 3 to the pad, which is conducive to improving accuracy of the identification and is more in line with an actual usage requirement.

In some embodiments, a distance from the marker 3 to the first busbar 21 is a, and a distance from the marker 3 to the second busbar 22 is b, wherein a range of a is 9 mm≤a≤18 mm, and a range of b is 9 mm≤b≤18 mm.

In some embodiments, a difference between a and b is 1 mm to 9 mm, that is, 1 mm≤|a-b|≤9 mm.

The distance from the marker 3 to the first busbar 21 may be 9 mm, 10 mm, 11 mm, 12 mm, 13 mm, 14 mm, 15 mm, 16 mm, 17 mm, 18 mm, or the like. The distance from the marker 3 to the second busbar 22 may be 9 mm, 10 mm, 11 mm, 12 mm, 13 mm, 14 mm, 15 mm, 16 mm, 17 mm, 18 mm, or the like. A difference between the distance from the marker 3 to the first busbar 21 and the distance from the marker to the second busbar 22 may be 1 mm, 2 mm, 3 mm, 4 mm, 5 mm, 6 mm, 7 mm, 8 mm, 9 mm, or the like.

Through such a design, there may be a certain difference between a and b, thereby reducing a possibility that it is not conducive to distinguishing whether the corresponding busbar 2 is a positive busbar or a negative busbar caused by increased identification difficulty due to excessively close values of a and b. When the values of a and b are excessively close, it is easy to cause impossible identification or incorrect identification due to factors such as machining accuracy. By presetting the difference between a and b, a and b can be clearly distinguished, thereby facilitating the identification and improving accuracy of the identification.

In some embodiments, a distance from the marker 3 to the first pad 211 is m, and a distance from the marker 3 to the second pad 221 is n, wherein a range of m is 9 mm≤m≤18 mm, and a range of n is 9 mm≤n≤18 mm.

In some embodiments, a difference between m and n is 1 mm to 9 mm, that is, 1 mm≤|m-n|≤9 mm.

The distance from the marker 3 to the first pad 211 may be 9 mm, 10 mm, 11 mm, 12 mm, 13 mm, 14 mm, 15 mm, 16 mm, 17 mm, 18 mm, or the like. The distance from the marker 3 to the second pad 221 may be 9 mm, 10 mm, 11 mm, 12 mm, 13 mm, 14 mm, 15 mm, 16 mm, 17 mm, 18 mm, or the like. A difference between the distance from the marker 3 to the first pad 211 and the distance from the marker to the second pad 221 may be 1 mm, 2 mm, 3 mm, 4 mm, 5 mm, 6 mm, 7 mm, 8 mm, 9 mm, or the like.

Through such a design, the difference between the distances from the marker 3 to the first pad 211 and from the marker 3 to the second pad 221 can be more obvious, thereby facilitating identification of the polarity of the corresponding busbar 2 by identifying the distances from the marker 3 and the pads. Such a design can reduce the possibility of impossible identification or incorrect identification caused by increased identification difficulty due to excessively close values of m and n.

In some embodiments, the marker 3 includes a first marker 31 and a second marker 32, a distance from the first marker 31 to the first pad 211 is m, and a distance from the second marker 32 to the second pad 221 is n. Values of m and n may satisfy the foregoing data range.

Through such a design, there may be a certain difference between m and n, thereby reducing a possibility that it is not conducive to distinguishing whether the corresponding busbar 2 is a positive busbar or a negative busbar caused by increased identification difficulty due to excessively close values of m and n.

As shown in FIG. 2, in some embodiments, the marker 3 is not collinear with the first pad 211 and the second pad 221. That is, the marker 3 is not in the same row as the first pad 211 and the second pad 221. Along an extension direction of the busbar 2, there is a gap between the marker 3 and the first pad 211 and between the marker 3 and the second pad 221.

A distance from the marker 3 to the first pad 211 is m, and a distance from the marker 3 to the second pad 221 is n. A distance from the marker 3 to the first busbar 21 is a, and a distance from the marker 3 to the second busbar 22 is b. A distance between the first pad 211 and the second pad 221 may be approximately equal to a distance between the first busbar 21 and the second busbar 22. When the marker 3 is collinear with the first pad 211 and the second pad 221, m+n is approximately equal to a+b. When the marker 3 is not collinear with the first pad 211 and the second pad 221, a line connecting the marker 3, the first pad 211, and the second pad 221 may approximately form a triangle, and the distance between the first pad 211 and the second pad 221 is approximately equal to the distance between the first busbar 21 and the second busbar 22. According to a principle that a sum of two sides of a triangle is greater than a third side, m+n is greater than a+b. Therefore, the design that the marker 3 is not collinear with the pads is conducive to increasing the distances from the marker 3 to the pads, thereby facilitating the measurement of the distances between the marker 3 and the pads and reducing the difficulty of measurement and identification, and is more conducive to identifying the corresponding busbars, thereby improving accuracy of identification of the busbars.

In some embodiments, the marker 3 may be in a shape of a circle, a rectangle, a triangle, or the like.

The shape of the marker 3 may be selected according to an actual requirement, to reduce a possibility of a short circuit in the solar cell due to simultaneous contact of the marker 3 with a plurality of busbars 2 and/or fingers 4. When the solar cell includes a plurality of markers 3, shapes and sizes of the markers 3 may be the same or different.

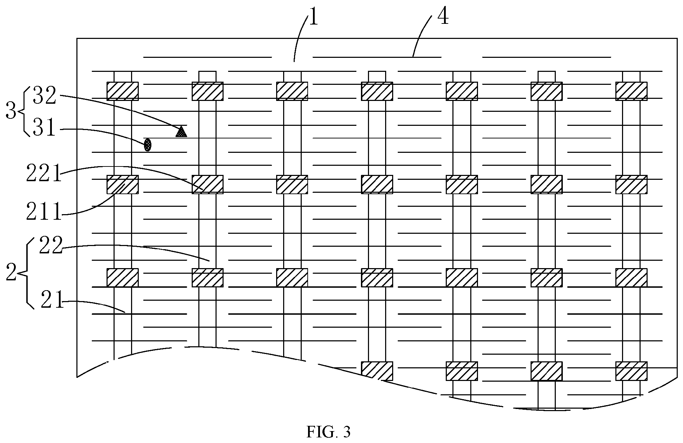

As shown in FIG. 3, in some embodiments, the first busbar 21 is adjacent to the second busbar 22, the marker 3 includes a first marker 31 and a second marker 32, the first marker 31 and the second marker 32 are located between the first busbar 21 and the second busbar 22, the first marker 31 is located on a side of the second marker 32 close to the first busbar 21, and the second marker 32 is located on a side of the first marker 31 close to the second busbar 22. The first marker 31 and the second marker 32 have different shapes.

Such a design can further facilitate the confirmation of the positive and negative electrodes of the busbar 2 through the marker 3. The shape of the marker 3 can be used to distinguish whether the marker 3 is the first marker 31 or the second marker 32, so that whether the busbar 2 adjacent to the marker 3 is the first busbar 21 or the second busbar 22 can be determined, thereby determining the polarity of the corresponding busbar 2.

As shown in FIG. 4, in some embodiments, the marker 3 includes a first marker 31 and a second marker 32, the first marker 31 is arranged on the first busbar 21, the second marker 32 is arranged on the second busbar 22, and the first marker 31 and the second marker 32 have different shapes.

Through such a design, whether the corresponding busbar 2 is the first busbar 21 or the second busbar 22 can be distinguished by detecting the shape of the marker 3, thereby knowing the polarity of the corresponding busbar 2. The busbar 2 is identified through the shape of the marker 3 in combination with the distance from the marker 3 to the pad, which can facilitate knowing the polarity of the busbar 2, and is more convenient in actual use.

In some embodiments, an area of a single marker 3 is 0.3 mm² to 4 mm².

The area of the single marker 3 may be 0.3 mm², 0.6 mm², 0.9 mm², 1.2 mm², 1.5 mm², 1.8 mm², 2.1 mm², 2.4 mm², 2.7 mm², 3.0 mm², 3.3 mm², 3.6 mm², 3.9 mm², 4.0 mm², or the like.

When the area of the marker 3 is excessively small, it is easy to increase the difficulty of identifying the marker 3, which is not conducive to identification. When the area of the marker 3 is excessively large, the marker is likely to come into contact with a plurality of busbars 2 and/or fingers 4, resulting in a short circuit. Moreover, an excessively large marker 3 may block a surface of the solar cell and affect light absorption efficiency of the solar cell. Therefore, the area of the marker 3 may be 0.3 mm² to 4 mm². Through such a design, the marker 3 can be easily identified, and a possibility of simultaneous contact of the single marker 3 with the plurality of busbars 2 and/or fingers 4 can be reduced, thereby reducing a risk of a short circuit in the solar cell caused by the marker 3.

In some embodiments, the marker 3 is made of silver paste.

If the marker 3 is made of silver paste, the marker 3 can be printed simultaneously during the printing of the busbars 2 and/or the fingers 4, thereby saving machining steps and improving machining efficiency. The marker 3 may alternatively be made of other materials, but the marker 3 is required to be printed separately during the machining, resulting in cumbersome machining procedures, reduced efficiency, and increased costs.

Based on the solar cell provided in the above embodiments, some embodiments of the present application further provide a photovoltaic module. The photovoltaic module includes solar cells. The solar cells may be the solar cell as referred to in any one of the above embodiments. The solar cells may be electrically connected in the form of an entirety or multiple slices to form solar cell strings. A plurality of solar cell strings are electrically connected in series and/or in parallel. The photovoltaic module may further include a packaging layer and a cover plate. The packaging layer covers a surface of the solar cell string, and the cover plate covers a side of the packaging layer away from the solar cell string. Along a thickness direction of the photovoltaic module, two opposite sides of the solar cell string may each be provided with the packaging layer and the cover plate.

During soldering of the solar cell strings, polarities of the first busbar 21 and the second busbar 22 may be judged through the marker 3 arranged on the solar cell, so as to acquire the polarity of the busbar of the solar cell to reduce a possibility of incorrect electrical connection of the solar cells.

The present application discloses a solar cell and a photovoltaic module. The solar cell includes a substrate 1, busbars 2, and at least one marker 3. The busbars 2 are arranged on a same side of the substrate 1, and include at least a first busbar 21 and a second busbar 22, the first busbar 21 and the second busbar 22 have opposite polarities, the first busbar 21 has a first pad 211, the second busbar 22 has a second pad 221, the first pad 211 and the second pad 221 are arranged sequentially along a straight line parallel to an arrangement direction of the busbars 2, and a distance from a same marker 3 to the first pad 211 is different from a distance to the second pad 221. Through such a design, the polarity of the corresponding busbar 2 can be judged as positive or negative according to distances from the marker 3 to different pads, which is conducive to identifying the polarity of the busbar 2 and facilitating electrical connection of solar cells.

The constructions, features, and functions of the present application are described in detail in the embodiments with reference to the accompanying drawings. The foregoing is merely preferred embodiments of the present application, but the implementation scope of the present application is not limited by the accompanying drawings. The protection scope of the present invention is defined by the claims.

## Claims

1. A solar cell, comprising:
a substrate (1);
busbars (2) arranged on a same side of the substrate (1); and
at least one marker (3) arranged on the substrate (1);
wherein the busbars (2) comprise at least a first busbar (21) and a second busbar (22), the first busbar (21) and the second busbar (22) have opposite polarities;
wherein the first busbar (21) has at least one first pad (211), the second busbar (22) has at least one second pad (221), the at least one first pad (211) and the at least one second pad (221) are arranged sequentially along a straight line parallel to an arrangement direction of the busbars (2), and a distance from a marker (3) of the at least one marker (3) to a corresponding first pad (211) of the at least one first pad (211) is different from a distance from a same marker (3) to a corresponding second pad (221) of the at least one second pad (221);
wherein at least two markers (3) are provided; and the at least two markers (3) are arranged on the busbars (2).

2. The solar cell according to claim 1, wherein an odd number of busbars (2) are provided, and along the arrangement direction of the busbars (2), adjacent busbars (2) have opposite polarities.

3. The solar cell according to claim 1, wherein,
along the arrangement direction of the busbars (2), two outermost busbars (2) are two first busbars (21), the busbar (2) adjacent to each of the two first busbars (21) is the second busbar (22), and the at least two markers (3) comprise a first marker (31) and a second marker (32); and
wherein the first marker (31) is arranged on one of the two first busbars (21), the second marker (32) is arranged on the second busbar (22) adjacent to the other one of the two first busbars (21), and a distance between the first marker (31) and a corresponding first pad (211) of the at least one first pad (211) is different from a distance between the second marker (32) to a corresponding second pad (221) of the at least one second pad (221).

4. The solar cell according to claim 3, wherein
the at least two markers (3) comprise a first marker (31) and a second marker (32), wherein the first marker (31) is arranged on the first busbar (21), and the second marker (32) is arranged on the second busbar (22); and
the first marker (31) and the second marker (32) have different shapes.

5. The solar cell according to claim 2, wherein the first busbar (21) is adjacent to the second busbar (22), and along the arrangement direction of the busbars (2), the at least one marker (3) is located between the first busbar (21) and the second busbar (22).

6. The solar cell according to claim 5,wherein a distance from one of the at least one marker (3) to the first busbar (21) is represented as a, a distance from a same marker (3) to the second busbar (22) is represented as b, where a≠b.

7. The solar cell according to claim 6, wherein the distance a from the marker (3) to the first busbar (21) satisfies 9 mm≤a≤18 mm, and the distance b from the marker (3) to the second busbar (22) satisfies 9 mm≤b≤18 mm, and/or
a distance difference |a-b| between the distance a from the marker (3) to the first busbar (21) and the distance b from the marker (3) to the second busbar (22) satisfies 1 mm≤|a-b|≤9 mm.

8. The solar cell according to claim 5, wherein the at least one marker (3) comprises a first marker (31) and a second marker (32);
wherein the first marker (31) is located on a side of the second marker (32) close to the first busbar (21), and the second marker (32) is located on a side of the first marker (31) close to the second busbar (22); and
the first marker (31) and the second marker (32) have different shapes.

9. The solar cell according to any one of claims 1-8, wherein
a distance m from a marker of the at least one marker (3) to a corresponding first pad (211) of the at least one first pad (211) satisfies 9 mm≤m≤18 mm, a distance n from the at least one marker (3) to the a corresponding second pad (221) of the at least one second pad (221) satisfies 9 mm≤n≤18 mm, and/or
wherein a distance difference |m-n| between the distance m from a marker of the at least one marker (3) to a corresponding first pad (211) of at least one the first pad (211) and the distance n from the marker (3) to a corresponding second pad (221) of the at least one second pad (221) satisfies 1 mm≤|m-n|≤9 mm.

10. The solar cell according to any one of claims 1-8, wherein an area of a single marker (3) of the at least one marker ranges from 0.3 mm² to 4 mm².

11. The solar cell according to any one of claims 1-8, wherein the at least one marker (3) is in a shape of at least one of a circle, a rectangle, and a triangle.

12. The solar cell according to any one of claims 1-8, wherein the at least one marker (3) is made of silver paste.

13. The solar cell according to according to any one of claims 1-8, wherein the at least one marker (3) is not collinear with the first pad (211) and the second pad (221).

14. The solar cell according to any one of claims 1-8, wherein the solar cell is a back contact solar cell, the busbars (2) and the at least one marker (3) are all arranged on a back surface of the substrate (1),
wherein the first busbar (21) and the second busbar (22) are arranged in an interdigitated manner, and the first pad (211) and the second pad (221) are arranged in a same row along a direction intersecting the arrangement direction of the busbars (2).

15. A photovoltaic module, comprising a solar cell according to any one of claims 1 to 14.
